# EUROPÄISCHE PATENTSCHRIFT

(11) **EP 2 267 377 B1**
(45) Veröffentlichungstag und Bekanntmachung des Hinweises auf die Patenterteilung: **25.01.2012**
(21) Anmeldenummer: 10005877.5
(22) Anmeldetag: 08.06.2010
(51) Int. Cl.: F24J 2/52

(54) **Beschickungsfahrzeug für einen Montageautomaten für Photovoltaikmodule**
Feeder vehicle for an assembly machine for photovoltaic modules
Véhicule de revêtement pour un automate de montage pour modules photovoltaïques

(30) Priorität: 12.06.2009 DE 102009024740
(43) Veröffentlichungstag der Anmeldung: 29.12.2010
(73) Patentinhaber: Adensis GmbH, 01129 Dresden (DE)
(72) Erfinder: Beck, Bernhard, 97332 Volkach OT. Dimbach (DE)

(56) Entgegenhaltungen:
- DE-A1- 4 237 773
- DE-A1- 10 246 161
- JP-A- 60 226 376
- Gregory S. Hickey, Brett Kennedy, Tony Ganino: "Intelligent Mobile Systems for Assembly, Maintenance and Operations for Space Solar Power", Jet Propulsion Laboratory - California Institute of Technology Proceedings of the Space and Robotics Conference 2000 - Albuquerque, New Mexico, USA, 27. Februar 1999 (1999-02-27), XP002609249, DOI: 10.1061/40476(299)6) Gefunden im Internet: URL:http://trs-new.jpl.nasa.gov/dspace/bit stream/2014/18679/1/99-2062.pdf [gefunden am 2010-11-12]

## Beschreibung

Die Erfindung betrifft ein Bodenfahrzeug zum Transport eines Gutes oberhalb von einem quer zur Fahrtrichtung verlaufenden Hindernis. Das Dokument DE 42 37 773 A1 offenbart ein solches Bodenfahrzeug, das als gehender Roboter ausgebildet ist Anwendungszweck der Erfindung ist die Beschickung eines Montageautomaten mit Photovoltaikmodulen, wobei der Montageautomat auf bereits montierten Photovoltaikmodulen verfahrbar ist und die noch zu montierenden Photovoltaikmodule oberhalb eines Traggerüstes für die Aufnahme der Photovoltaikmodule dem Montageautomaten angeboten werden. Das Bodenfahrzeug selber ist aber unabhängig von seiner Verwendung zu sehen. So können Gegenstände beliebiger Art auch Personen, die sich oberhalb des Gerüsts befinden, zur Handnahme angeboten werden.

Ein derartiger Montageautomat ist von der Anmelderin entwickelt worden und befindet sich bereits auf Baustellen im Einsatz. Die Baustellen sind PhotovoltaikGroßanlagen, die in der Regel rechteckförmige Abmessungen von mehreren 100 Metern Kantenlänge haben. Insbesondere in den USA sind Großanlagen in Planung, bei denen sich Traggerüste über mehrere Kilometer erstrecken. Zur Zeit müssen die einzelnen Photovoltaikmodule dem Montageautomaten per Hand angereicht werden, was einen erheblichen finanziellen Aufwand bedeutet, wenn man sich die Anzahl von vielen Tausend zu montierenden PV-Modulen vor Augen hält. Die Erfindung verlässt die klassische Überlegung, wie es möglich sein könnte, einen oberhalb eines relativ engmaschigen Traggerüstes befindlichen Montageautomaten mittels eines Gerätes von unten, durch die Lücken im Montagegerüst hindurch mit relativ großformatigen PV-Modulen zu versorgen. Im Gegenteil geht sie von dem Ansatz aus, wie ein Bodenfahrzeug in die Lage versetzt werden kann, oberhalb des Traggerüstes befindliche PV-Module mittels des Bodenfahrzeugs transportieren zu können, obwohl die Querholme des Traggerüstes im Wege stehen.

Entsprechend liegt der vorliegenden Erfindung die Aufgabe zugrunde, den Montageprozess bei Photovoltaikgroßanlagen weiter zu automatisieren, indem die zu montierenden PV-Module dem Montageautomaten oberhalb des Traggerüstes angeboten werden.

Diese Aufgabe wird durch mindestens sechs jeweils paarweise in Fahrtrichtung beabstandet angeordnete, senkrecht verschiebbare Stempel gelöst, oberhalb von denen sich die zu montierenden PV-Module befinden, und durch eine Einrichtung zur Zeitsteuerung, die bewirkt, dass immer erst ein eingefahrener Stempel eines Paares ausgefahren wird, bevor der andere Stempel des Paares abgesenkt wird.

Die drei Stempelpaare sind im Dreieck so angeordnet, dass ein Stapel PV-Module, der sich oberhalb der Stempel befindet, sicher getragen wird. Dies kann z.B. unter anderem mit Hilfe einer Ablage geschehen, die auf ihrer Unterseite mit sechs Einbuchtungen versehen ist, in welche jeweils einer der Stempel im ausgefahrenen Zustand eingreift. Die Oberseite der insbesondere flächigen Ablage ist eben ausgebildet und - ähnlich wie eine Palette - zur Aufnahme eines Stapels an PV-Modulen geeignet. Es ist auch möglich, die Palette selber als Unterlage zu verwenden.

Es werden also durch die drei Stempelpaare mindestens drei Auflagepunkte für die PV-Module bereitgestellt. Es sind auch acht Stempel denkbar, die dann vier Stempelpaare bilden und die Ablage oder alternativ die PV-Module an der Nähe ihrer vier Ecken abstützen. Im Sinne dieser Erfindung ist jedes Paar von Stempeln dahingehend zu sehen, dass aus einer möglichen Vielzahl von Stempeln, wie z.B. vier Stempel pro Auflageregion, zumindest jeweils zwei für einen anstehenden Zyklus paarweise arbeiten. Für einen nächsten Zyklus können dann zwei andere von den vier Stempeln günstiger positioniert sein, um z.B. Geländeunebenheiten auszugleichen.

Im Betrieb des Bodenfahrzeugs wird dieses vom offenen Ende eines Ganges zwischen zwei Reihen an Erdstützen des Traggerüstes ausgerichtet. Wenn der erste, in Fahrtrichtung liegende Stempel in die Nähe des ersten Querholmes (auch Modulschiene genannt) kommt oder diesen berührt, wird sein hinter ihm angeordnetes Pendant im Paar ausgefahren, bis beide Stempel des Paares an der Ablage oder den PV-Modulen anliegen. Anschließend wird der vorne liegende Stempel eingezogen, so dass er unter den Querholm hindurch passt. Jetzt kann das Bodenfahrzeug um eine Strecke, die dem Abstand zwischen den Stempeln eines Paares entspricht, in Richtung des Ganges verfahren werden. Der erste Stempel schiebt sich dabei unter den Querholm hindurch und bleibt abgesenkt, bis sein Pendant den Querholm berührt. Dann wird er angehoben, bis er in die Einbuchtung der Ablage eingreift, beziehungsweise bis er an der Unterseite des Stapels der zu montierender PV-Module anliegt. Zu diesem Zeitpunkt liegen also wieder beide Stempel des Paares an der Ablage oder direkt an den PV-Modulen an. Folgend wird das Pendant (entspricht dem zweiten oder hinteren Stempel des Stempelpaares) abgesenkt, so dass es unter den ersten Querholm hindurch passt. Schließlich wird das Bodenfahrzeug so weit entlang des Ganges vorgefahren, bis entweder das folgende Stempelpaar am ersten Querholm anliegt oder das erste Stempelpaar den nächsten Querholm berührt oder sich ihm auf einen Mindestabstand genähert hat. Das Ereignis, welches früher eintritt, ist von der Länge der Ablage bzw. dem Abstand zwischen den Ausbuchtungen von Stempelpaar zu Stempelpaar und von dem Abstand der beiden Stempel eines Paares abhängig.

Es kann von Vorteil sein, wenn die Stempel in ihrer Länge variabel ausfahrbar sind, so dass die Ablage in einem vorgebbaren Abstand planparallel zu der von den Querholmen aufgespannten Fläche gehalten wird. Diese Maßnahme ermöglicht es, mit kurzen Stempelwegen auszukommen, was die Zeit reduziert, die für die Betätigung der Stempel bis zu ihrer Endlage verstreicht.

Es ist vorteilhaft, wenn nach dem Unterfahren eines Querholms sofort wieder der entgegengesetzt zur Fahrtrichtung liegende Stempel (oben der zweite Stempel oder auch das Pendant genannt) ausgefahren wird. Es sind dann im normalen Fahrzustand immer beide Stempel eines Paares unterstützend wirksam, was der Stabilität dient. Außerdem läuft der Fahrvorgang insgesamt schneller ab, da bei der Annäherung des ersten Stempels an einen Querholm der Stempel sofort abgesenkt werden kann, ohne auf das Ausfahren des hinteren Stempels warten zu müssen. So muss das Bodenfahrzeug erst dann anhalten, wenn der erste Stempel den Querholm passiert hat und der Wechsel der Lastübernahme erfolgt (durch Ausfahren des ersten, bereits passierten Stempels und Absenken des Pendantstempels zur Vorbereitung der Unterquerung).

Die Entscheidung, ob drei oder vier Stempelpaare vorteilhafter sind, ist ebenfalls von der Geometrie der Anlage abhängig. Drei Stempelpaare bedeuten weniger Steuerungsaufwand, aber mehr Zeitaufwand bei den Vorfahrschritten, da das Bodenfahrzeug bei dem mittleren Stempelpaar wieder anhalten muss, was entfällt, wenn vier Stempelpaare an den Enden der Ablage eingreifen. Andererseits ist es, abhängig von der Form der PV-Module, insbesondere ihres Länge/Breite-Verhältnisses, auch möglich, drei Stempelpaare vorzusehen, von denen eines mittig am Rand zwischen zwei Ecken angeordnet ist, und die zwei anderen Stempelpaare jeweils an den Ecken des gegenüberliegenden Randes. Dieses wäre die zuerst zu prüfende Alternative, da hier relativ große Verfahrschritte bei kleinem Steuerungsaufwand möglich sind.

Die Detektion, wann ein Stempel einen Querholm erreicht, kann z.B. mittels eines Laserstrahls vorgenommen werden, der den entsprechenden Abstand misst und der Steuerung zuleitet. Die einfachste Art stellen wohl Berührungssensoren dar, die bei Kontakt mit einem Querholm reagieren. Solch ein Berührungssensor sollte federbelastet sein, um nach dem Kontakt wieder zusammen mit dem zugehörigen Stempel abgesenkt werden zu können. Es sind im Grunde genommen alle gängigen Vorgehensweisen möglich, wie zum Beispiel auch ein kapazitiv arbeitender Näherungssensor.

Das Bodenfahrzeug sollte soweit automatisiert sein, dass jedem Zyklus, d.h. jedem Stempelausfahrvorgang und dem folgenden Stempelabsenkvorgang, eine Fahrbewegung folgt, die insbesondere mittels eines Schrittmotors realisiert wird. Die Vorschubschritte können jeweils eine Länge zwischen 1 cm und 5 cm haben.

Eine vorteilhafte Ausgestaltung zeichnet sich dadurch aus, dass die Einbuchtungen trichterförmig sind, und dass die Enden der Stempel kegelstumpfartig ausgeführt sind. Das bietet hinreichend Toleranz dafür, dass beim Ausfahren des Stempels dieser Stempel auch auf die Einbuchtung trifft. Zumindest eines der Teile Stempel oder Ausbuchtung sollte aus einem elastischen Material, wie z.B. Hartgummi, bestehen. Auch eine Mischform von einer Einbuchtung aus Teflon und einem Stempelende aus Gummi ist sinnvoll.

Wie zuvor angedeutet, umfaßt das Traggerüst eine Vielzahl von Erdstützen, die mit einem Ende in den Boden verankert sind und an deren freien Enden Längsholme angebracht sind. Auf den Längsholmen wiederum sind Querholme montiert, die zur Aufnahme der PV-Module dienen. Diese sind dort z.B. mittels Klammern befestigt. Die Erdstützen bilden dabei parallele Reihen, zwischen zwei von denen sich jeweils ein Gang ausbildet. Diesen Gang entlang muss das Bodenfahrzeug fahren. Um im wesentlichen mittig zwischen den Stützen zu fahren, ist das Bodenfahrzeug vorteilhafterweise mit einer Zentriereinrichtung versehen, die verhindert, dass es zu nah an die Erdstützen heranfährt oder diese gar berührt.

Ein besonderer Vorteil wird in einer niedrigen Bauhöhe des Bodenfahrzeugs gesehen. Diese sollte bei eingefahrenen Stempeln gemessen nicht höher als 0,5 Meter bis 1,0 Meter sein. Die Bauhöhe der Photovoltaikanlage ist aus Gründen der Windbelastung der Photovoltaikanlage möglichst niedrig zu halten. Eine praktikable Montage erfordert hingegen eine akzeptable Bauhöhe. Ein niedriges automatisiertes Bodenfahrzeug, das die Montage von unten her unterstützt, ermöglicht hier, die Bauhöhe weiter abzusenken, ohne ein Einbuße beim Montagekomfort hinnehmen zu müssen.

Im Betrieb sollten zwei Bodenfahrzeuge bereitstehen, die von jeweils einem Ganganfang/-ende aus den Montageautomaten bedienen. Dieses ermöglicht die optimale Nutzung des Automaten, da ein Bodenfahrzeug herausgefahren und neu mit zu montierenden Modulen beladen werden kann, während das andere Fahrzeug den Montageautomat beschickt. Ein Füllstandssensor, der misst, wie viele PV-Module noch am Montageautomaten sind, kann frühzeitig ein Signal abgeben, um das andere Fahrzeug auf den Weg zum Automaten zu bringen.

Weitere Vorteile und Ausgestaltungen der Erfindung ergeben sich aus der Beschreibung von Ausführungsbeispielen anhand der Figuren. Es zeigen:
- Fig. 1: die Ausführung eines zur Zeit typischen Traggerüstes für Photovoltaikmodule;
- Fig. 2a bis 2d: ein Bodenfahrzeug in Seitenansicht in unterschiedlichen Positionen;
- Fig. 3a bis 3c: Varianten einer Unterlage in Aufsicht;
- Fig. 4: eine Seitenansicht einer Photovoltaikanlage mit steiler montierten Modulschienen; und
- Fig. 5 und 6: eine Ausführung eines Traggerüsts für Großanlagen gemäß der Patentanmeldung DE 10 2009 024 738.

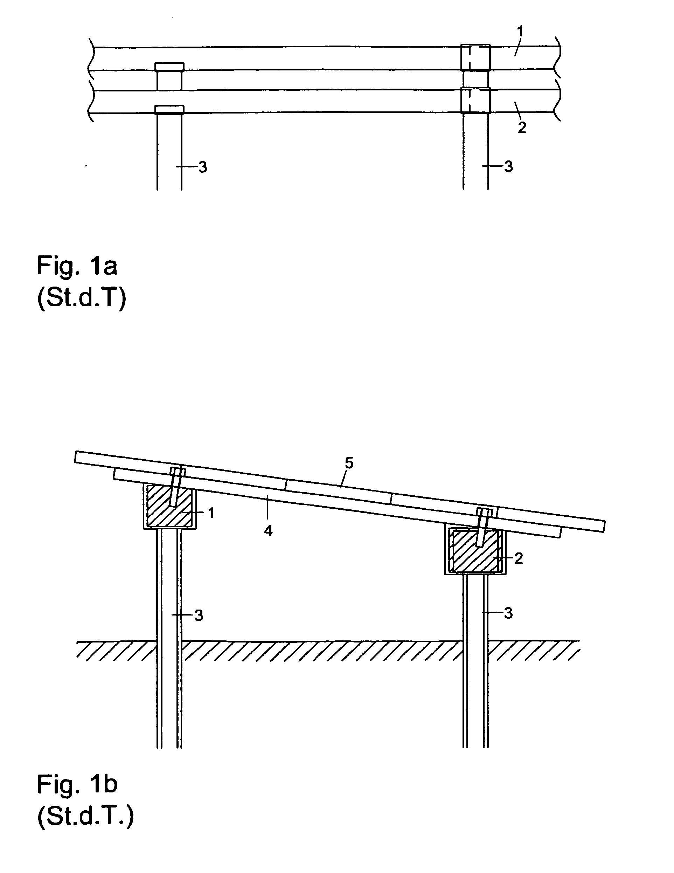

In den Figuren 1a und 1b sind zwei Schienen oder Träger 1,2 dargestellt, welche auf leicht unterschiedlicher Höhe verlaufen. Die Schienen 1,2 sind auf Erdstützen 3 befestigt, die entsprechend dem unterschiedlichen Höhenverlauf der Träger 1,2 unterschiedliche Längen aufweisen. Die Erdstützen 3 sind entweder direkt in den natürlichen Boden eingerammt oder mittels eines Fundamentes (nicht gezeigt) mit dem Boden verbunden. In beiden Fällen ergibt sich auf Bodenniveau ein unverrückbares Auflager für die Erdstützen 3.

In der Figur 1b ist der Querholm, dh. die Modulschiene 4 dargestellt, auf die Module 5 zur Aufnahme von Sonnenenergie montiert werden. Die Modulschiene 4 kann unmittelbar auf den zwei Trägern 1,2 verschraubt werden.

Es ist zu berücksichtigen, dass sich die Neigung (sofern die Erdstützen 3 nicht auf derselben Höhe sind) an den später beschriebenen Hub der Stempel orientiert. Die Bezugszeichen 1 bis 5 gelten nur für die Figur 1 nach dem Stand der Technik und werden bei den folgenden Figuren ersetzt durch andere Bezugszeichen.

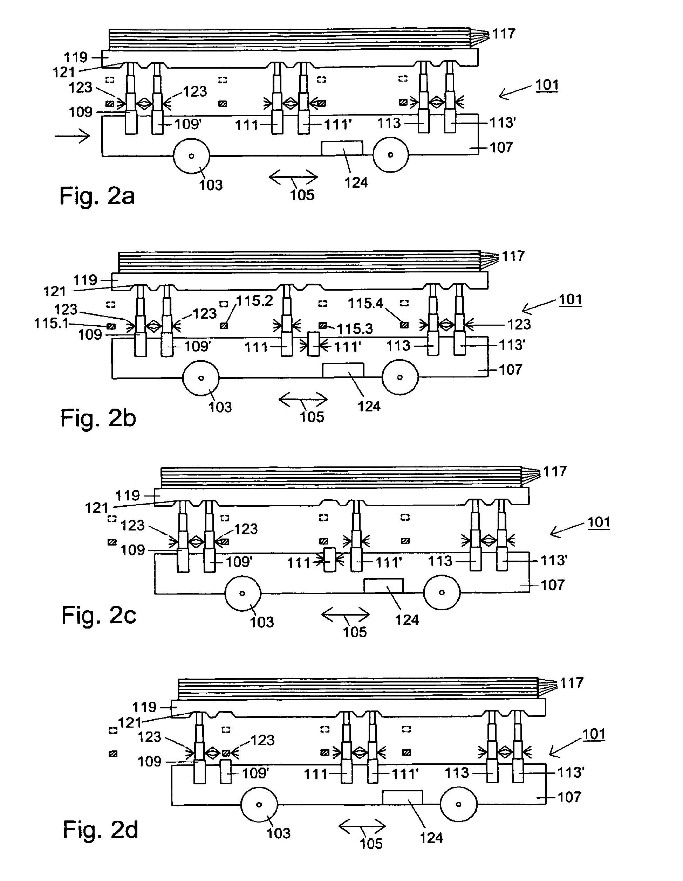

In den Figuren 2a bis 2d ist ein Bodenfahrzeug 101 in einer Seitenansicht mit teilweiser Schnittdarstellung zu unterschiedlichen Wegpositionen gezeigt. Das Bodenfahrzeug 101 bewegt sich auf seinen Rädern 103 entlang des Doppelpfeils 105, was der Fahrtrichtung entspricht. Entlang des Doppelpfeils 105 deswegen, weil es nach seiner Entladung wieder an seine Ausgangsposition zurückgeführt werden muss. Das Bodenfahrzeug 101 ist mit einem Gestell 107 versehen, an oder auf welchem drei Stempelpaare mit den Stempeln 109-109', 111-111' und 113-113' montiert sind. Die Stempel 109-109', 111-111' und 113-113' sind vorzugsweise hydraulische Stempel, die einen Ausfahrhub zwischen 10 cm und 30 cm haben. Je kürzer der Hub, desto schneller können der Absenk- und der Ausfahrvorgang abgeschlossen werden.

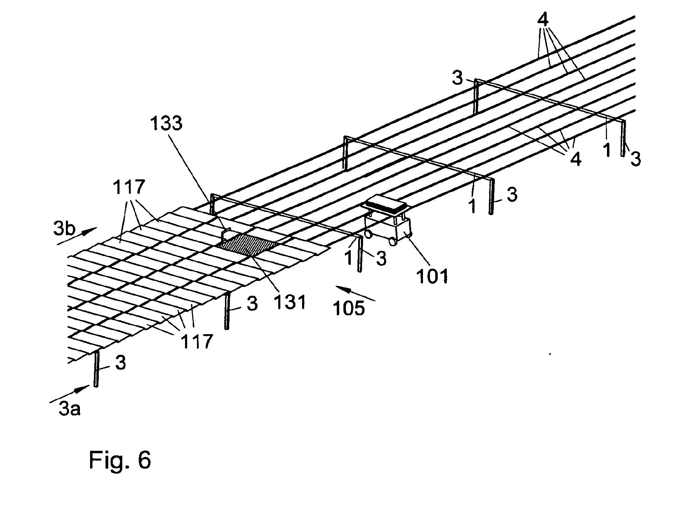

In den Figuren 2a bis 2d sind weiterhin als Hindernis für die freie Verfahrbarkeit des Bodenfahrzeugs 101 vier Querholme oder Modulschienen 115₁ bis 115₄ gezeigt, die den Modulschienen 4 aus der (Stand der Technik) Figur 1 entsprechen. Der obere, jeweils gestrichelt gezeichnete Teil symbolisiert dabei den höher gelegenen Abschnitt der Modulschienen 115, die unter einer Steigung verlaufen. Auf ihnen sind, in der Regel mittels Klammern (nicht gezeigt), die Photovoltaikmodule befestigt. Auf den bereits montierten PV-Modulen bewegt sich ein Montageautomat 131 (siehe Figur 6) selbstständig mittels Saugnäpfen weiter. Diesem Automaten 131 werden von vorliegendem Bodenfahrzeug 101 Photovoltaikmodule 117 oberhalb der Querholme 115₁ bis 115₄ zur Montage angeboten. Die Photovoltaikmodule 117 sind auf der Oberseite einer Unterlage 119 gestapelt. Der Stapel kann durch nicht gezeigte seitliche Halteelemente gegen ein Verrutschen gesichert sein. Auf der Unterseite ist die Unterlage 119 mit sechs Einbuchtungen oder Vertiefungen 121versehen, die einen trichterförmigen Zugang für die Stempel 109-109', 111-111' und 113-113' bilden. Dabei ist jeder Vertiefung 121 ein Stempel 109-109', 111-111' und 113-113' zugeordnet.

Die Figur 2a zeigt eine Position des Bodenfahrzeugs 101, in welcher alle Stempel 109-109', 111-111' und 113-113' ausgefahren sind, und das Bodenfahrzeug in die rechte Richtung verfährt, bis einer der vorderen Stempel 109',111' oder 113' in die Nähe des Querholm 115₃ kommt. Im gezeigten Ausführungsbeispiel ist dies der vordere Stempel 111' des mittleren Stempelpaares 111-111'. Die kritische Nähe wird über Annäherungssensoren 123 gemessen, die symbolisch mit einer Strahlenbündel an den Stempeln dargestellt ist. Die kritische Nähe kann soweit vorverlegt werden, dass noch im Vorwärtsfahrbetrieb des Bodenfahrzeugs 101 ausreichend Zeit verbleibt, um den Stempel 111' abzusenken, so dass der Querholm 115₃ ohne ein Anhalten des Bodenfahrzeugs 101 passiert werden kann. Die kritische Nähe kann aber auch die Berührung des Querholms 111' sein, woraufhin das Bodenfahrzeug 101 anhält, den Stempel 111' herunterfährt und erneut zur Unterquerung beschleunigt. Die Signale der Annäherungssensoren 123 werden einer Zeitsteuerung 124 zugeführt, die bewirkt, dass immer erst ein eingefahrener Stempel eines Paares 109, 111, 113 ausgefahren wird, bevor der andere Stempel 109', 111', 113` des Paares abgesenkt wird. Die Zeitsteuerung 124 beinhaltet eine Steuereinrichtung (nicht gezeigt), die den Antrieb des Bodenfahrzeugs 101 ansteuert. Die Ansteuerung geschieht derart, dass immer nur eine Bewegung ermöglicht wird, wenn zumindest ein Stempel pro Paar 109, 111, 113 an der Unterseite der Unterlage 119 anliegt und zugleich keiner der Stempel 109, 109',111, 111'. 113, 113, 209, 209', 211, 211', 213, 213', 309, 309', 311, 311',313, 313' und 315, 315' unmittelbar vor einem der Querholme 115 ansteht.

In der Figur 2c ist das Bodenfahrzeug 101 soweit vorgefahren, dass der vordere Stempel 111' des mittleren Stempelpaares 111,111' wieder ausgefahren werden konnte, um die Unterlage 119 abzustützen, und jetzt der hintere Stempel 111 abgesenkt wurde, um ein weiteres Vorfahren des Bodenfahrzeugs 101 zu ermöglichen.

Die Figur 2d zeigt noch eine weitere folgende Position, in der beide Stempel 111,111' des mittleren Stempelpaares 111-111' wieder ausgefahren sind, und der vordere Stempel 109' des hinteren Stempelpaares 109,109' den Querholm 115₂ unterquert.

Im Betrieb des Bodenfahrzeugs wird für das Aus- und Einfahren der Stempel 109-109', 111-111' und 113-113' jeweils eine Zeit im Sekundenbereich benötigt, so dass das Bodenfahrzeug 101 so zügig vorfahren kann, dass es immer vor dem Montageautomaten an der nächsten Montagestelle für das nächste PV-Modul 117 ankommt. Zur zügigen Fortbewegung trägt auch bei, wenn das Bodenfahrzeug 101 unmittelbar nach jedem Stempelzyklus eines Stempelpaares eine Beschleunigung initiiert. Dabei ist ein Vorfahren in vielen kleinen Schritten von 1 cm bis 5 cm sinnvoll, um auch bei unebenem Untergrund immer rechtzeitig vor einem Stempel 109-109', 111-111' und 113-113' anhalten zu können.

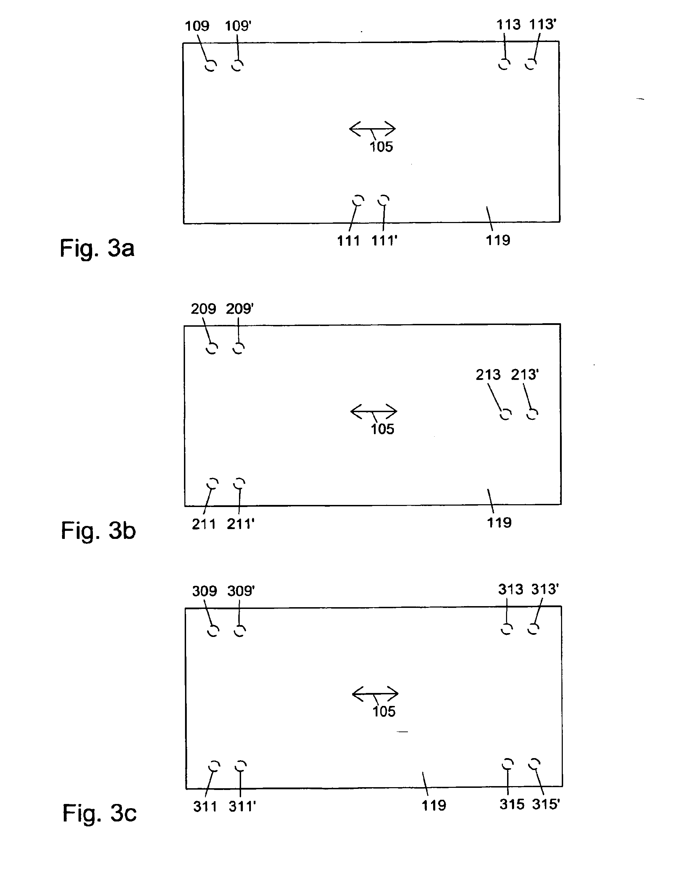

In den Figuren 3a bis 3c ist jeweils eine Unterlage 119 mit den Stellen gezeigt, die für die Aufnahme der Stempel 109-109', 111-111' und 113-113' vorgesehen ist. In der Figur 3a ist die in der Figur 2 verwendete Unterlage mit drei Stempelpaaren109-109', 111-111' und 113-113' auf verschiedener Höhe dargestellt. Die Figur 3b zeigt eine Variante mit drei Stempelpaaren 209-209', 211-211' und 213-213', wobei die zwei Stempelpaare 209-209', 211-211' auf gleicher Höhe bezüglich des Fahrwegs angeordnet sind. Diese Ausführungsform ist etwas instabiler als die vorhergehende, bietet jedoch Vorteile bei der Steuerung und der Fahrgeschwindigkeit. Bei einem exakten Geradeauslauf des Bodenfahrzeugs 101 werden die Stempelpaare 209-209', 211-211' immer zeitgleich an demselben Querholm 115 anlangen und können ergo auch gemeinsam betätigt werden. Die Figur 3c zeigt eine Alternative mit vier Stempelpaaren 309-309', 311-311',313-313' und 315-315' von denen jeweils zwei Paare 309-309', 311-311' einerseits und 313-313' und 315-315' andererseits gemeinsam betätigt werden können und gleichzeitig eine gute Stabilität der Unterlage mit den Stapel von Photovoltaikmodulen auf ihr gegeben ist.

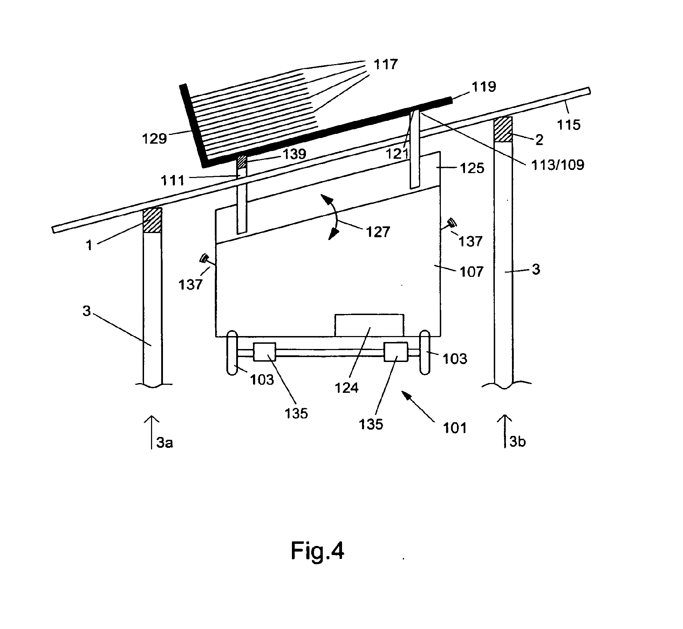

In der Figur 4 ist eine Seitenansicht der Photovoltaikanlage mit steiler montierten Modulschienen 115 als im vorhergehenden Beispiel gezeigt. Das Fahrzeug 101 fährt senkrecht zur Blattebene und ist in dahingehend gegenüber dem zuvor beschriebenen Fahrzeug 101 modifiziert, dass das Gestell 107, an welchem auch die Stempelpaare 109 bis 113 befestigt sind, eine in der Neigung verstellbare Montageplatte 125 aufweist, welche die Stempelpaare 109,111,113 trägt. Die Neigung wird durch ein Schwenken der Montageplatte 125 entlang des gekrümmten Doppelpfeils 127 und anschließendem Einrasten eingestellt und entspricht nach der Einstellung im Wesentlichen der der vorhandenen Neigung der Modulschienen 115. Damit über den gesamten vorgesehenen Bereich der Neigungsverstellung der Montageplatte 125 trotzdem ein senkrechtes Aus- und Einfahren der Stempel 109 bis 111' möglich ist, müssen die Halterungen der Stempelpaare 109 bis 113 über geeignete mechanische Verstellmittel ebenfalls in ihrer Neigung in Bezug zur Montageplatte 125 verstellbar sein. In der Figur 4 ist noch zu erkennen, dass das Bodenfahrzeug 101 durch zwei Motoren 135, insbesondere Schrittmotoren angetrieben wird. Wenn eine Richtungskorrektur erforderlich ist, wird nur auf einen der beiden Motoren 135 ein Stromimpuls gegeben, wodurch eine Drehbewegung des Bodenfahrzeugs bewirkt wird. Dabei wird die Fahrrichtung mit Hilfe einer zwei Antennen 137 umfassenden Zentriereinrichtung erkannt, die physikalische Wellen ausstrahlen und empfangen, und dadurch den Abstand zu den Reihen 3a, 3b justieren können. Der Abstand muss dabei nicht mittig zwischen den Reihen 3a, 3b sein, sondern das Bodenfahrzeug kann auch auf eine asymmetrische liegende Spur zentriert werden.

Weiterhin ist aus der Figur 4 noch ein Gewichtssensor 139 ersichtlich, der am Kopfende von zumindest einem der Stempel bei zumindest einem Stempelpaar 109,111,113 angebracht ist. Das Messen des Gewichts erlaubt es, die Vorratsmenge an gespeicherten Photovoltaikmodulen 117 zu erfassen und bei Unterschreiten einer Mindestanzahl gegebenenfalls schon eine Maßnahme, wie die Vorbereitung einer weiteren Unterlage 119 mit Modulen 117 oder deren Transport von einem Lager zu initiieren.

Weiterhin ist die Unterlage 119 modifiziert, indem sie eine Seitenwand 129 hat, die senkrecht von der Grundfläche der Unterlage 119 abgewinkelt ist und sich zumindest entlang dem unteren Rand der Unterlage 119 erstreckt. Die Seitenwand 129 verhindert ein Abrutschen der Photovoltaikmodule von der Unterlage 119. Die Einbuchtungen 121 verhindern dabei ein Verrutschen der Unterlage 119 selber von den Enden der ausgefahrenen Stempel.

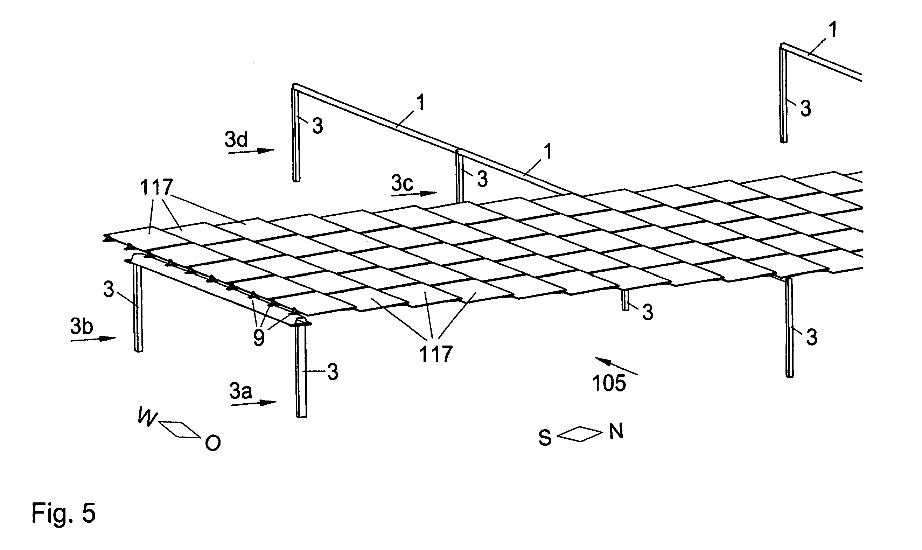

Die Figuren 5 und 6 zeigen ein Großgerüst zur Montage von Photovoltaikmodulen 117. In der Figur 5 ist der Ausschnitt einer Photovoltaikanlage gezeigt, der vier durch einen Pfeil angedeutete Reihen 3a bis 3d von Erdstützen 3 umfasst. Von Erdstütze 3 zu Erdstütze 3 ist jeweils ein Träger 1 montiert, wobei jede Reihe 3a bis 3d durchlaufend mit einer Querschiene 4 wie bei einer Modelleisenbahn versehen ist. Es ist auch denkbar, Träger 1 vorzusehen, die mehr als den Abstand zwischen zwei Erdstützen 3 überspannen, so dass nicht auf jeder Erdstütze 3 eine Fuge ist. So können z.B. nur bei jeder zweiten oder dritten Erdstütze 3 die dann entsprechend längeren Träger 1 aneinanderstoßen. In der Figur 5 sind diesmal pro Träger 1 acht in Nord-Süd Richtung verlaufende Modulschienen 4 vorgesehen, die im gezeigten Beispiel vier nebeneinander liegende PV-Module 117 aufnehmen.

Die Figur 6 zeigt einen Streifen aus der betrachteten PV-Freiflächenanlage, bei dem zwei Reihe 3a bis 3b von Erdstützen 3 in Folge gezeigt sind. Die acht nebeneinander liegenden Modulschienen 4 sind als Flachbandeisen ausgeführt, welches durchlaufend über alle Träger 1 geführt ist. Die Länge der Modulschiene 4 in Form des Flachbandeisens wird nur durch die Handhabbarkeit der Rolle, zu dem das Flacheisen angeliefert wird begrenzt. In der Figur 6 ist der Montageautomat 131 mit einem Greifarm 133 zu erkennen, der auf montierten Photovoltaikmodulen 117 verfährt und mittels seines Greifarms 133 noch nicht montierte Photovoltaikmodule 117 von der Unterlage 119 abheben kann.

### Bezugszeichenliste

- 1: Träger
- 2: Träger
- 3: Erdstütze
- 4: Modulschiene, Querholm
- 5: Module
- 101: Bodenfahrzeug
- 103: Rad
- 105: Doppelpfeil
- 107: Gestell
- 109: erstes Stempelpaar
- 111: zweites Stempelpaar
- 113: drittes Stempelpaar
- 115: Modulschiene, Querholm
- 117: Photovoltaikmodule
- 119: Unterlage
- 121: Einbuchtung
- 123: Annäherungssensor
- 124: Zeitsteuerung
- 125: Montageplatte
- 127: gekrümmter Doppelpfeil
- 129: Seitenwand
- 131: Montageautomat
- 133: Greifarm
- 135: Schrittmotor
- 137: Antenne
- 139: Gewichtssensor
- 109-109', 111-111' und 113-113': Stempelpaare
- 209-209', 211-211' und 213-213': Stempelpaare
- 309-309', 311-311',313-313' und 315-315': Stempelpaare
- 115.1 - 115.4: Modulschienen

## Patentansprüche

1. Bodenfahrzeug (101) zum Transport eines Gutes oberhalb von einem quer zur Fahrtrichtung verlaufenden Hindernis, **gekennzeichnet durch** mindestens sechs jeweils paarweise in Fahrtrichtung (105) beabstandet angeordnete, senkrecht verschiebbare, das Gut tragende Stempel (109-109', 111-111' und 113-113') und **durch** eine Zeitsteuerung, die bewirkt, dass immer erst ein eingefahrener Stempel (109,111,113) eines Paares ausgefahren wird, bevor der andere Stempel (109',111',113') des Paares abgesenkt wird.

2. Bodenfahrzeug nach Anspruch 1, **dadurch gekennzeichnet, dass** das Gut Photovoltaikmodule (117) sind und das Hindernis ein Teil (115) eines Traggerüstes ist, wobei das Bodenfahrzeug (101) zur Beschickung eines Montageautomaten (131) mit den Photovoltaikmodulen (117) verwendet wird, wobei der Montageautomat oberhalb bereits montierter Photovoltaikmodule versetz- oder verfahrbar ist und die noch zu montierenden Photovoltaikmodule (117) oberhalb des Teils (115) des Traggerüstes für die Aufnahme der Photovoltaikmodule dem Montageautomaten angeboten werden.

3. Bodenfahrzeug nach Anspruch 2, **dadurch gekennzeichnet, dass** die noch zu montierenden Photovoltaikmodule (117) auf einer Ablage (119) abgelegt sind, die auf ihrer Unterseite mit sechs Einbuchtungen (121) versehen ist, in welche jeweils zumindest einer der Stempel eines Paares (109-109', 111-111' und 113-113') im ausgefahrenen Zustand eingreift.

4. Bodenfahrzeug nach Anspruch 3, **dadurch gekennzeichnet, dass** jedem Stempel (109-109', 111-111' und 113-113') ein Annäherungs- oder Berührungssensor (123) zugeordnet ist, der beim Ansprechen ein Anheben des Stempels (109-109', 111-111' und 113-113') und ein Absenken des anderen Stempels (109-109', 111-111' und 113-113') desselben Paares auslöst, wobei das Ansprechen des Sensors (123) in Abhängigkeit des Abstands des Stempels (109-109', 111-111' und 113-113') von einem Querholm (115) des Traggerüstes erfolgt.

5. Bodenfahrzeug nach Anspruch 4, **dadurch gekennzeichnet, dass** die Stempel (109-109', 111-111' und 113-113') in ihrer Länge variabel ausfahrbar sind, so dass die Ablage (119) in einem vorgebbaren Abstand planparallel zu der von den Querholmen (115) aufgespannten Fläche gehalten wird.

6. Bodenfahrzeug nach Anspruch 4 oder 5, **dadurch gekennzeichnet, dass** jeder Absenk- und Ausfahrzyklus eines Stempelpaares (109-109', 111-111' und 113-113') eine Fahrbewegung initiiert.

7. Bodenfahrzeug nach Anspruch 4 oder 5, **dadurch gekennzeichnet, dass** eine Fahrbewegung mit Hilfe eines Schrittmotors (135) erfolgt, der ein Fahren in vorgegebenen Schritten von 1 cm bis 5 cm Länge bewirkt.

8. Bodenfahrzeug nach einem der Ansprüche 3 bis 7, **dadurch gekennzeichnet, dass** die Einbuchtungen (121) trichterförmig und die Enden der Stempel (109-109', 111-111' und 113-113') kegelstumpfförmig ausgeführt sind.

9. Bodenfahrzeug nach einem der Ansprüche 2 bis 8, **dadurch gekennzeichnet, dass** es zum Betrieb zwischen zwei parallelen Reihen (3a,3b) von Erdstützen (3) des Traggerüsts geeignet ist und eine Zentriereinrichtung (137) aufweist, die die Fahrspur im wesentlichen mittig zwischen den Reihen hält.

10. Bodenfahrzeug nach einem der Ansprüche 1 bis 9, **dadurch gekennzeichnet, dass** es bei eingefahrenem Stempeln (109-109', 111-111' und 113-113') eine Bauhöhe zwischen 0,5 Meter und 1,0 Meter aufweist.

11. Bodenfahrzeug nach einem der Ansprüche 1 bis 10, **dadurch gekennzeichnet, dass** der Stempelhub zwischen 10 cm und 30 cm liegt.

12. Bodenfahrzeug nach einem der Ansprüche 1 bis 11, **dadurch gekennzeichnet, dass** es einen Sensor (139) aufweist, der die Menge der noch zu montierenden Photovotaikmodule (117) misst und/oder die Entnahme des letzten Photovoltaikmoduls (117) signalisiert.

13. Bodenfahrzeug nach einem der Ansprüche 1 bis 12, **dadurch gekennzeichnet, dass** zwei Bodenfahrzeuge (101) vorhanden sind, die von gegenüber liegenden Seiten des Traggerüsts den Montageautomaten bedienen.

## Claims

1. Ground vehicle (101) for transporting objects above an obstacle running transversely to the travel direction, **characterized by** at least six pistons (109-109', 111-111' and 113-113') being arranged in pairs at a distance in travel direction (105), being vertically movable and carrying the objects and by a time control which causes that always a retracted piston (109, 111, 113) of a pair will be extended, before the other piston (109', 111', 113') of the pair will be lowered.

2. Ground vehicle according to claim 1, **characterized in that** the objects are photovoltaic modules (117) and the obstacle (115) is part of a support scaffolding, whereby the ground vehicle (101) is used for feeding an automatic assembly machine (131) with the photovoltaic modules (117), the automatic assembly machine being movable or traversable above photovoltaic modules which are already installed and the photovoltaic modules which still have to be installed (117) are offered above the element (115) of the support scaffolding to the automatic assembly machine for the picking-up of the photovoltaic modules.

3. Ground vehicle according to claim 2, **characterized in that** the photovoltaic modules which still have to be installed (117) are laid down on a support plate (119), which on its lower side is provided with six recesses (121) into which at least one of the pistons of a pair (109-109', 111-111' and 113-113') interlocks in extended condition.

4. Ground vehicle according to claim 3, **characterized in that** to each piston (109-109', 111-111' and 113-113') a proximity or contact sensor (123) is assigned which triggers, when it is tripped, an elevation of the piston (109-109', 111-111' and 113-113') and a lowering of the other piston (109-109', 111-111' and 113-113') of the same pair, whereby the sensor (123) is tripped in dependency on the distance of the piston (109-109', 111-111' and 113-113') from a transverse beam (115) of the support scaffolding.

5. Ground vehicle according to claim 4, **characterized in that** the pistons (109-109', 111-111' and 113-113') are variably extendable in length, so that the support plate (119) is plane-parallely kept at a predeterminable distance to the surface spanned by the transverse beams (115).

6. Ground vehicle according to claim 4 or 5, **characterized in that** each lowering and extending cycle of a piston pair (109-109', 111-111' and 113-113') initiates a travel movement.

7. Ground vehicle according to claim 4 or 5, **characterized in that** a movement is carried out by means of a stepper motor (135), which causes a travel movement in predetermined steps of a length of 1 cm to 5 cm.

8. Ground vehicle according to one of the claims 3 to 7, **characterized in that** the recesses (121) are funnel-shaped and the ends of the pistons (109-109', 111-111' and 113-113') have the shape of a truncated cone.

9. Ground vehicle according to one of the claims 2 to 8, **characterized in that** it is suitable for operation between two parallel rows (3a, 3b) of ground supports (3) of the support scaffolding and that it comprises a centering device (137) which maintains the travel path substantially midway between the rows.

10. Ground vehicle according to one of the claims 1 to 9, **characterized in that** the vehicle has a construction height of between 0.5 and 1.0 metre, in case of retracted pistons (109-109', 111-111' and 113-113').

11. Ground vehicle according to one of the claims 1 to 10, **characterized in that** the stroke of the pistons is between 10 cm and 30 cm.

12. Ground vehicle according to one of the claims 1 to 11, **characterized in that** it comprises a sensor (139) which measures the quantity of the photovoltaic modules (117) still to be installed and/or signalizes the removal of the last photovoltaic module (117).

13. Ground vehicle according to one of the claims 1 to 12, **characterized in that** there are two ground vehicles (101) which operate the automatic assembly machine from opposite sides of the support scaffolding.

## Revendications

1. Véhicule terrestre (101) pour le transport des objets au-dessus d'un obstacle s'étendant transversalement vers la direction de course, **caractérisé par** au moins six pistons (109-109', 111-111' et 113-113') étant arrangés par paires à distance en direction de course (105), étant verticalement déplaçable et portant les objets et par un contrôle du temps qui cause que toujours un piston escamoté (109, 111, 113) d'une paire sera sorti, avant que l'autre piston (109', 111', 113') de la paire soit baissé.

2. Véhicule terrestre selon la revendication 1 **caractérisé en ce que** les objets sont des modules photovoltaïques (117) et l'obstacle est un élément (115) d'un échafaudage portatif, le véhicule terrestre (101) étant utilisé pour l'alimentation d'un robot d'assemblage (131) avec les modules photovoltaïques (117), le robot d'assemblage étant déplaçable ou mobile au-dessus des modules photovoltaïques déjà assemblés et les modules photovoltaïques encore à assembler (117) étant offerts au robot d'assemblage au-dessus de l'élément (115) de l'echafaudage portatif pour la prise des modules photovoltaïques.

3. Véhicule terrestre selon la revendication 2 **caractérisé en ce que** les modules photovoltaïques encore à assembler (117) sont déposés sur une plaque de support (119) qui est muni de six échancrures (121) sur sa face inférieure, dans lesquelles au moins un des pistons d'une paire (109-109', 111-111', 113-113') s'encliquète en état sorti.

4. Véhicule terrestre selon la revendication 3 **caractérisé en ce qu'**un détecteur de proximité ou un capteur de contact (123), qui déclenche, quand il est activé, un levage du piston (109-109', 111-111', 113-113') et un abaissement de l'autre piston de la même paire, est associé à chaque piston (109-109', 111-111' et 113-113'), l'activation du détecteur (123) se faisant en dépendance de la distance du piston (109-109', 111-111', 113-113') d'une traverse (115) de l'échafaudage portatif.

5. Véhicule terrestre selon la revendication 4 **caractérisé en ce que** les pistons (109-109', 111-111' et 113-113') peuvent être prolongés variablement en long, de sorte que la plaque de support (119) est tenue plan-parallèlement à une distance prédéterminable vers la surface définée par les traverses (115).

6. Véhicule terrestre selon la revendication 4 ou 5 **caractérisé en ce que** chaque cycle d'abaissement et de prolongation d'une paire de pistons (109-109', 111-111' et 113-113') initie un mouvement.

7. Véhicule terrestre selon la revendication 4 ou 5 **caractérisé en ce qu'**il y a un mouvement par le moyen d'un moteur pas à pas (135), qui cause un mouvement à des pas prédéterminés d'une longueur de 1 cm à 5 cm.

8. Véhicule terrestre selon l'une des revendications 3 à 7 **caractérisé en ce que** les échancrures (121) sont en forme d'entonnoir et les bouts des pistons (109-109', 111-111' et 113-113') sont en forme de cône tronqué.

9. Véhicule terrestre selon l'une des revendications 2 à 8 **caractérisé en ce qu'**il est convenable au fonctionnement entre deux rangées parallèles (3a,3b) de soutiens sur le terrain (3) de l'échafaudage portatif et qu'il comprend un dispositif de centrage (137) tenant la voie de circulation essentiellement en centre entre les rangées.

10. Véhicule terrestre selon l'une des revendications 1 à 9 **caractérisé en ce qu'**il a une hauteur de construction entre 0,5 mètres et 1,0 mètres, en cas que les pistons (109-109', 111-111' et 113-113') soient escamotés.

11. Véhicule terrestre selon l'une des revendications 1 à 10 **caractérise en ce que** la levée des pistons est entre 10 cm et 30 cm.

12. Véhicule terrestre selon l'une des revendications 1 à 11 **caractérisé en ce qu'**il comprend un détecteur (139), mésurant la quantité des modules photovoltaïques encore à assembler (117) et/ou signalant la prise du dernier module photovoltaïque.

13. Véhicule terrestre selon l'une des revendications 1 à 12 **caractérise en ce qu'**il y a deux véhicules terrestres (101) qui alimentent le robot d'assemblage de faces opposées de l'échafaudage portatif.
